# EUROPEAN PATENT APPLICATION

(11) **EP 4 704 503 A1**
(43) Date of publication of application: **04.03.2026**
(21) Application number: 24197927.7
(22) Date of filing: 02.09.2024
(51) Int. Cl.: H05K 7/14, H05K 7/20

(54) **ENCLOSURE FOR POWER CONVERSION SYSTEMS**

(71) Applicant: Hitachi Energy Ltd, 8050 Zürich (CH)
(72) Inventor: GEORGE, Robin, 31-445 Krakow (PL); RUSZCZYK, Adam, 30-316 Krakow (PL); SOWA, Kacper, 33-342 Barcice (PL)
(74) Representative: Zacco Sweden AB

(57) **Abstract**

Embodiments of the present disclosure provide an enclosure (100) for power conversion system (400), comprising: first block (102) having first alignment means (104); second block (106) having second alignment means (108) adapted to align with first alignment means (104) to interlock first block (102) with second block (106). Interlocked first block (102) and second block (106) creates internal compartment to enclose cooling components (110). Enclosure (100) comprises at least one rib structure (112), arranged on internal wall of each of first block (102) and second block (106) to position and fixate cooling components (110) inside enclosure. Each of first block (102) and second block (106) comprises openings (114) to dissipate heat produced by heating elements through heat exchange with cooling components positioned inside enclosure. Disclosure further relates to power conversion system (400) and method (500) for arranging cooling components (110) of power conversion system.

## Description

### TECHNICAL FIELD

The present disclosure relates generally to a field of power conversion system. More particularly, it is related to an enclosure for a power conversion system, the power conversion system, a method for arranging cooling components of the power conversion system.

### BACKGROUND

Power conversion systems are critical components in various industries, including renewable energy, electric vehicles, telecommunications, and industrial automation. Efficient thermal management is critical for ensuring effective performance of the power conversion systems. Heat sinks are commonly used to dissipate heat generated by electronic components, such as power semiconductors in the power conversion systems. An enclosure housing the heat sinks or other components of the power conversion systems plays a crucial role in ensuring reliable and safe operation of the power conversion systems. However, traditional methods for arranging heat sinks often involve mounting structures, which are complex, time-consuming and expensive to manufacture.

Conventional method for assembling heat sinks which are not grounded electrically mostly relies on isolators, even grounded heat sinks demand intricate sheet metal fixtures. The conventional methods are time consuming, since isolators are required for assembling one heat sink. Further, along with the isolators, additional fixtures and more mounting points are often required to provide more strength to a design structure to enclose the heat sinks and for assembling all the heat sinks to meet a desired design of structural arrangement of heat sinks.

Furthermore, there are other constraints in the conventional methods which include tight tolerance requirement, risk of broken isolators, potential distortion of mechanical structure which may alter clearance and creepage distance between two conductive parts of the power conversion system.

Further, in the traditional design structure, a separate diffuser made of metal sheet may be required for assembling fans, one or more electronics components of the power conversion system such as power board, control board, etc. The diffuser often requires electrical isolation from the heat sinks, which makes the assembling method more complicated. Due to the above-mentioned constraints, the assembling time are becoming high and contribute to elevated production costs.

### SUMMARY

Consequently, there is a need for an improved enclosure for power conversion systems. The proposed enclosure is designed to ensure proper protection and provide assembly for one or more cooling components of the power conversion systems.

It is therefore an object of the present disclosure to provide an enclosure for power conversion systems, a power conversion system, and method for arranging one or more cooling components, which mitigate, alleviate, or eliminate all or at least some of the above-discussed drawbacks of presently known solutions.

This and other objects are achieved by means of an enclosure for power conversion systems, a power conversion system, and method for arranging one or more cooling components, as defined in the appended claims. The term exemplary is in the present context to be understood as serving as an instance, example or illustration.

According to a first aspect of the present disclosure, there is provided an enclosure for power conversion systems. The enclosure comprises of a first block having first alignment means, a second block having second alignment means adapted to align with the first alignment means to interlock the first block with the second block. The interlocked first block and the second block creates an internal compartment arranged to enclose one or more cooling components of the power conversion systems. The enclosure further comprising at least one rib structure. The rib structure is arranged on internal wall of each of the first block and the second block to position and fixate the one or more cooling components of the power conversion systems inside the enclosure. Each of the first block and second block comprises one or more openings to dissipate heat produced by one or more heating elements of the power conversion systems through heat exchange with one or more cooling components positioned inside the enclosure.

Therefore, embodiments herein provide the enclosure comprising a plurality of blocks (such as first block, second block) which are interlocking, and electrically isolating. The blocks are interlocked to other blocks resulting in reducing number of fixtures. The proposed design can have one or more building blocks where heat sinks are constrained automatically when assembled and thus, the proposed design reduces the assembling complexity which also reduces assembling time. Further, the proposed embodiments eliminate a need of tight tolerance requirement and thus, improves strength against impact loads.

Advantageously, in the proposed design of the enclosure, because of the at least one rib structure arrangement on internal wall of each of the first block and the second block, the one or more cooling components are self- aligned and creating a gap between the one or more cooling components, which also eliminates need of isolators between the one or more cooling components (heat sinks).

Furthermore, the enclosure provides one or more openings which helps to dissipate heat produced by one or more heating elements of the power conversion systems through heat exchange with one or more cooling components positioned inside the enclosure, thus improving efficiency and longevity of the power conversion systems.

In some embodiments, the first block comprises a plurality of first sub-blocks, wherein each first sub-block comprises protruding means and slots, wherein slots are adapted to accommodate the one or more protruding means attaching the plurality of first sub-blocks to each other.

In some embodiments, the second block comprises a plurality of second sub-blocks, wherein each second sub-block comprises protruding means and slots, wherein slots are adapted to accommodate the one or more protruding means attaching the plurality of second sub-blocks to each other.

In some embodiments, the first alignment means, and the second alignment means comprises protruding means and slots, wherein the slots are adapted to accommodate the one or more protruding means to attach the first block and the second block to each other to form a sealed enclosure for housing the one or more cooling components of the power conversion systems.

In some embodiments, the interlocked first block and the second block creates an internal compartment arranged to enclose at least two cooling components of the power conversion systems and wherein the at least one rib structure is of variable dimensions and is arranged on the internal wall of each of the first block and the second block to maintain a predefined distance, allowing the at least two cooling components of the power conversion system to be electrically isolated from each other.Advantageously, further, the proposed embodiments eliminate risk of change in position of the one or more cooling components as variable clearance and creepage distance are maintained on the internal wall of the enclosure. Furthermore, also because of variable clearance and creepage distance, one or more mounting space of different dimensions are created for assembling fans, and one or more electronic components such as control boards, PCB's etc.

Advantageously, the proposed design of the enclosure can have one or more building blocks where one or more cooling components (heat sinks) are constrained automatically when assembled. Thus, eliminating the need for designing separate diffuser and its assembly to heat sinks. Furthermore, the proposed design of enclosure eliminates the need of separate isolators/rubber headings to isolate heat sinks with enclosure and also eliminate the need of providing mounting holes on heat sinks.

In some embodiments, the one or more cooling components of the power conversion systems comprises heat sinks.

In some embodiments, the enclosure comprises each of the first block and the second block comprising one or more mounting surfaces to assemble fans and/or one or more electronic components of the power conversion systems.

Advantageously, in the proposed embodiments, all the blocks when interlocked and assembled will create more mounting surfaces for assembling fans, and one or more electronic components such as control boards, PCB's, contactor, inductor, etc.

In some embodiments, the first block and/or the second block is constructed from electrically isolating materials.

Furthermore, sometimes the one or more electronic components such as PCBs are connected to ground potential, or different PCBs may need to be connected to different potential. As the first block and/or the second block is constructed from electrically isolating materials, the mounting surface created will have no negative impact even though the PCBs in the same mounting surface are connected to different potential.

According to a second aspect there is provided a power conversion system. The power conversion system comprising a power conversion circuit and an enclosure according to the first aspect, an arrangement integrated into the enclosure to dissipate heat generated by the power conversion circuit. The arrangement comprises one or more cooling components of the power conversion systems disposed within the enclosure.

Advantageously, the proposed enclosure ensures protection and provide assembly for the enclosed power conversion circuit and the one or more cooling components.

In some embodiments, the power conversion system comprises of at least one of a power board and a control board. The one or more cooling components disposed within the enclosure comprises at least one heat sink. The power board or control board are thermally connected to the at least one heat sink through at least one of the one or more openings provided in the enclosure.

According to a third aspect there is provided a method for arranging a plurality of one or more cooling components of a power conversion system. The method comprises steps of providing an enclosure. The enclosure comprises a first block and a second block. The method comprises arranging the one or more cooling components within the first block of the enclosure; and interlocking, the second block with the first block. The interlocked first block and the second block creates an internal compartment to enclose the one or more cooling components of the power conversion systems.

In some embodiments, the method further comprises contacting a heating element of the power conversion system to the one or more cooling components through at least one of said one or more openings provided in the enclosure.

Advantageously, the proposed method for assembling heat sinks is not relying on isolators. The proposed method for assembling heat sinks discloses a faster and self-aligning way to assemble heat sinks and thus reduce assembling time.

Other advantages may be readily apparent to one having skill in the art. Certain embodiments may have some, or all of the recited advantages.

### BRIEF DESCRIPTION OF THE DRAWINGS

The foregoing will be apparent from the following more particular description of the example embodiments, as illustrated in the accompanying drawings in which like reference characters refer to the same parts throughout the different views. The drawings are not necessarily to scale, emphasis instead being placed upon illustrating the example embodiments.
FIG. 1A discloses a schematic view of an example enclosure according to some embodiments;
FIG. 1B discloses a schematic view of a second block of an example enclosure according to some embodiments;
FIG. 2A-2B shows alternate schematic views of the example enclosure according to some embodiments;
FIG. 3A shows a schematic outer view of the example of assembled enclosure according to some embodiments;
FIG. 3B shows a schematic three-dimensional view of the example of assembled enclosure according to some embodiments;
FIG. 4 shows a block diagram of an example power conversion system according to some embodiments; and
FIG. 5 shows a flowchart illustrating example steps for a method for arranging one or more cooling components of a power conversion system according to some embodiments.

### DETAILED DESCRIPTION

Aspects of the present disclosure will be described more fully hereinafter with reference to the accompanying drawings. The enclosure disclosed herein can, however, be realized in many different forms and should not be construed as being limited to the aspects set forth herein. Like numbers in the drawings refer to like elements throughout.

The terminology used herein is for the purpose of describing particular aspects of the disclosure only and is not intended to limit the invention. It should be emphasized that the term "comprises/comprising" when used in this specification is taken to specify the presence of stated features, integers, steps, or components, but does not preclude the presence or addition of one or more other features, integers, steps, components, or groups thereof. As used herein, the singular forms "a", "an" and "the" are intended to include the plural forms as well, unless the context clearly indicates otherwise.

Embodiments of the present disclosure will be described and exemplified more fully hereinafter with reference to the accompanying drawings. The solutions disclosed herein can, however, be realized in many different forms and should not be construed as being limited to the examples set forth herein.

In the following description of exemplary embodiments, the same reference numerals denote the same or similar components.

Traditional methods for arranging heat sinks often involve complex mounting structures, which are complex, time-consuming and expensive to manufacture. Traditional design of enclosure for power conversion system is not only complex, but also expensive.

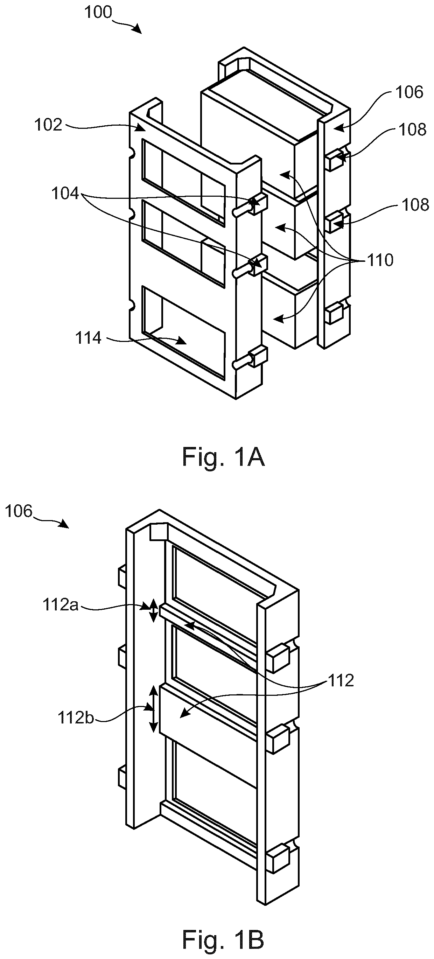

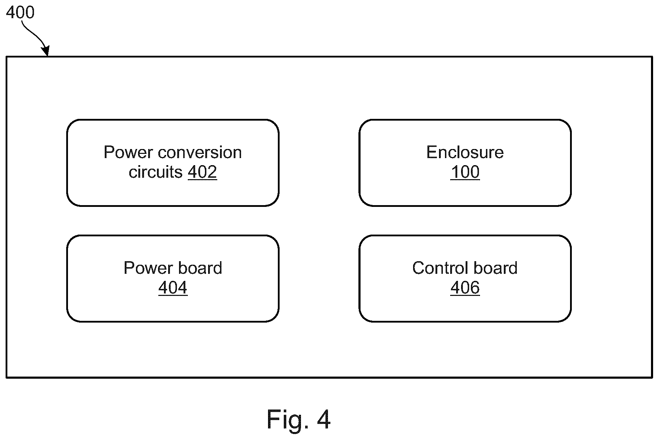

FIG. 1A shows a schematic view of an example enclosure (100) for enclosing one or more modules of power conversion systems (later as shown in FIG. 4). In an example, the power conversion systems may include and not limited to AC-DC converters, DC-AC converters, DC-DC converters, AC-AC converters, bidirectional converters, frequency converters, phase converters, etc. In an example, one or more modules of power conversion systems may include and not limited to electrical components which need electrical isolation and/or mechanical fixations, power conversion circuits, power boards and the control boards, heat sinks, etc.

As shown in FIG. 1A and FIG. 1B in combination, the enclosure (100) comprising a first block (102). The first block (102) is havingfirst alignment means (104). In an example, the alignment means (104) may include and not limited to slots, mounting points, etc. The enclosure (100) further comprises of a second block (106) having second alignment means (108). The second alignment means (108) are adapted to align with the first alignment means (104) to interlock the first block (102) with the second block (106). The interlocked first block (102) and the second block (106) creates an internal compartment. The internal compartment is arranged to enclose one or more cooling components (110) of the power conversion systems. In some embodiments, the one or more cooling components (110) of the power conversion systems comprises heat sinks. In an example, the enclosure (100) can be used to assemble one or more cooling components (110) such as electrical components which may need electrical isolation and/or mechanical fixations.

The enclosure (100) comprises at least one rib structure (112). The at least one rib structure (112) is arranged on internal wall of each of the first block (102) and the second block (106) to position and fixate the one or more cooling components (110) of the power conversion systems inside the enclosure (100). Each of the first block 102 and second block 106 comprises one or more openings (114) to dissipate heat produced by one or more heating elements of the power conversion systems through heat exchange with one or more cooling components positioned inside the enclosure (100). In an example, the one or more heating elements may include and not limited to resistors, chips or modules which generates heat, power modules, insulated-gate bipolar transistor (IGBT), resistors etc.

In some embodiments, the at least one rib structure (112) is of variable dimensions. The rib structure (112) is arranged on the internal wall of each of the first block (102) and the second block (106). As shown in FIG. 1B, rib structure (112) is arranged on the internal wall of each of the second block (106) to maintain a predefined distance (112a, 112b), allows the at least two cooling components (110) of the power conversion system to be electrically isolated from each other. The predefined distance (112a, 112b), also known as creepage and clearance distance allows the at least two cooling components (110) of the power conversion system to be electrically isolated from each other.

Advantageously, Further, the proposed embodiments eliminate risk of change in position of the one or more cooling components (110), as variable clearance and creepage distance (112a, 112b) are maintained on the internal wall of the enclosure (100).

Therefore, embodiments herein provide the enclosure (100) which is interlocking, modular structure and electrically insulating. The design of the first block (102) and second block (106) can be interlocking to each other and thus reduces a number of fixtures in the enclosure (100). The proposed design of the enclosure (100) can have one or more first block (102) and the second block (106), where one or more cooling components (110) are constrained automatically when assembled. Thus, reduces the assembly complexity and thereby reduces assembly time. Further, the proposed embodiments eliminate the need of tight tolerance requirements and improves strength of the enclosure (100) against impact loads.

Further, the enclosure (100) provides the one or more openings (114) which helps to dissipate heat produced by one or more heating elements (not shown in FIG.s) of the power conversion system through heat exchange with one or more cooling components (110) positioned inside the enclosure (100), thus improving efficiency and longevity of the power conversion systems.

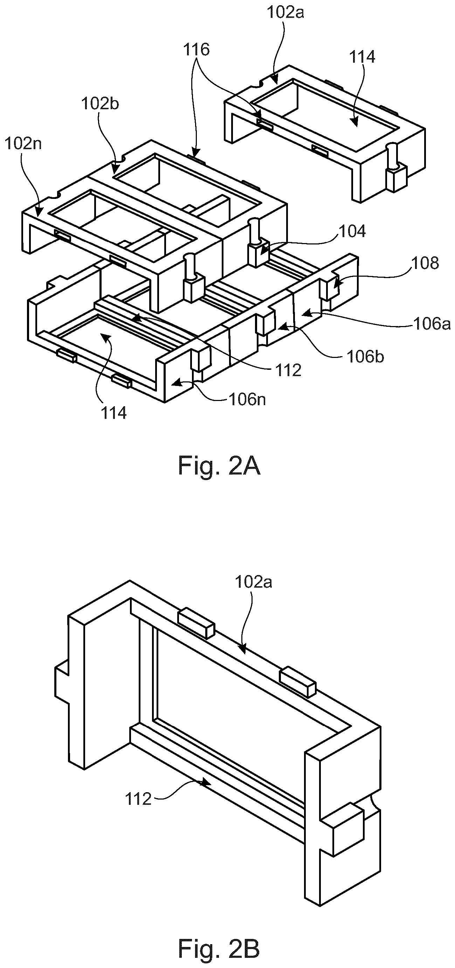

In some embodiment, as shown in FIG. 2A and FIG. 2B, the first block (102) comprises a plurality of first sub-blocks (102a, 102b, ...,102n). Each first sub-block (102) may comprise protruding means and slots (116). The slots (116) are adapted to accommodate the one or more protruding means connecting the plurality of first sub-blocks (102a, 102b, ..., 102n) to each other.

In some embodiments, the second block (106) comprises a plurality of second sub-blocks (106a, 106b, ... ,106n). Each second sub-block (106) comprises protruding means and slots (116). Slots (116) are adapted to accommodate the one or more protruding means connecting the plurality of second sub-blocks (106a, 106b, ..., 106n) to each other. FIG. 2B shows the schematic view of the first sub block (102a).

In some embodiments, referring to FIG. 1A again, for the sake of simplicity, each of the first block (102) and the second block (106) comprises only one sub-block. The first alignment means (104) and the second alignment means (108) comprises protruding means and slots (not shown in FIG. 1A). The slots are adapted to accommodate the one or more protruding means to attach the first block (102) and the second block (106) to each other to form a sealed enclosure for housing the one or more cooling components (110) of the power conversion systems.

In some embodiments, as shown in FIG. 2A, the first block (102) of the enclosure (100) comprises the plurality of first sub-blocks (102a, 102b, ...,102n). Each of the first sub-block (102) comprise the protruding means and slots (116). The slots are adapted to accommodate the one or more protruding means attaching the plurality of first sub-blocks (102a, 102b, ..., 102n) to each other. Similarly, the second block (106) comprises the plurality of second sub-blocks (106a, 106b, ... ,106n). Each of the second sub-block (106) comprises protruding means and slots (116). The slots (116) are adapted to accommodate the one or more protruding means attaching the plurality of second sub-blocks (106a, 106b, ..., 106n) to each other.

In some embodiments, referring to FIG. 2A again, the first alignment means (104) and the second alignment means (108) comprises protruding means and slots (116). The slots are adapted to accommodate the one or more protruding means to attach the first block (102) and the second block (106) to each other to form a sealed enclosure for housing the one or more cooling components (110) of the power conversion system.

In some embodiments, referring again to FIG. 1A - FIG. 2B, the interlocked first block (102) and the second block (106) creates an internal compartment arranged to enclose at least two cooling components (110) of the power conversion systems.

The blocks such as the first block (102) and/or the first sub-block (102a-102n), the second block (106) and/or the second sub-blocks (106a-106n) can be identical/different according to on the overall design of the enclosure (100). Further, the blocks/sub blocks can be interlocked. The modular design of the enclosure (100) allows for easy addition or removal of first block (102) or second block (106) or first sub block (102a) or second sub block (106a), enabling the enclosure (100) to accommodate power conversion system of various sizes. In addition, number of mounting points are reduced because of the interlocking. Furthermore, the modular design of the enclosure (100) facilitates easier access and maintenance of internal components of the power conversion system such as heat sinks, control boards, etc.

Advantageously, the proposed design of the enclosure (100) can have the one or more first block (102) and the second block (106) where one or more cooling components (110) (heat sinks) are constrained automatically when assembled. This automatic assembly eliminates a need for designing separate diffuser and its assembly to heat sinks. Furthermore, the proposed design of the enclosure (100) eliminates the need of separate isolators/rubber headings to isolate heat sinks (110) from the power conversion system (400) and also eliminate the need of providing mounting holes on the heat sinks (110). Since the proposed enclosure (100) may not require diffusers, separate isolators/rubber headings, this may reduce the manufacturing cost of the enclosure (100).

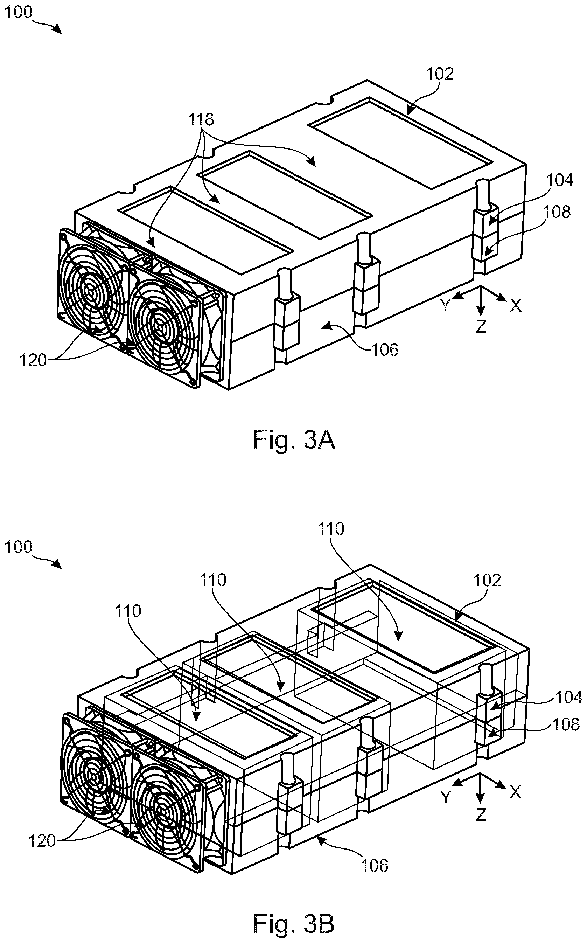

In some embodiments, as shown in FIG. 3A, each of the first block (102) and the second block (106) of the enclosure (100) comprises one or more mounting surfaces (118) to assemble fans and/or one or more electronic components (not shown in FIGs.) of the power conversion systems. The enclosure (100) may accommodate the fans or blowers to dissipate heat from the power conversion systems. In an example, the one or more electronic components may include and not limited to power boards, control boards, and other electronic components of the power conversion system.

FIG. 3B shows a schematic three-dimensional view of the example of assembled enclosure (100) according to some embodiments.

In some embodiments, the first block (102) and/or the second block (106) is constructed from electrically isolating materials. In an example, the electrically isolating materials may include and not limited to plastic, electrically insulating resins, a glass reinforced thermoset polyester sheet material such as GPO3, epoxy glass material (EPGC material), etc. In an example, the enclosure (100) may be made from light weight electrically isolating materials.

Referring to FIG. 4, the second aspect of this disclosure discloses the power conversion system (400). The power conversion system (400) may comprise power conversion circuits (402) and the enclosure (100) (as shown and described in FIG. 1A to FIG. 3B). An arrangement integrated into the enclosure (100) to dissipate heat generated by the power conversion circuits (402). The arrangement may comprise the one or more cooling components (110) of the power conversion systems disposed within the enclosure (100).

In some embodiments, the power conversion system (400) may comprise at least one of the power board (404) and the control board (406). The one or more cooling components (110) disposed within the enclosure (100) comprises at least one heat sink (not shown). The power board (404) or the control board (406) are thermally connected to the at least one heat sink through at least one of the one or more openings (114 as shown in FIG. 1A and FIG. 2A) provided in the enclosure (100).

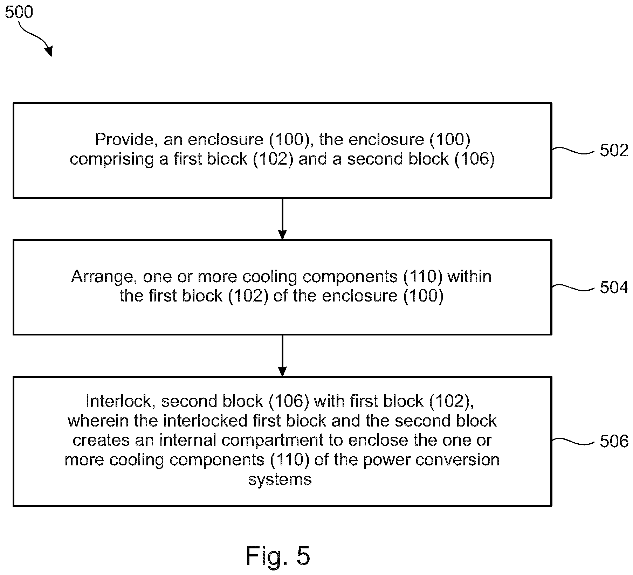

FIG. 5 is a flowchart illustrating example steps for a method (500) for arranging the one or more cooling components (110) of the power conversion system in the enclosure (100 as shown and described in FIG. 1A- FIG. 3B) according to some embodiments.

The order in which the steps of the method (500) is described is not intended to be construed as a limitation, and any number of the described method steps may be combined in any order to implement the method (500) or alternate methods. Additionally, individual steps may be deleted from the method (500) without departing from the scope of the invention as defined in the claims.

At step (502), the method (500) comprises providing, the enclosure (100 as shown and described in FIG. 1A- FIG. 3B).

At step (504), the method (500) comprises arranging, the one or more cooling components (110) within the first block (102) of the enclosure (100).

At step (506), the method comprises interlocking (506), the second block (106) with the first block (102). The interlocked first block (102) and the second block (106) creates an internal compartment to enclose the one or more cooling components (110) of the power conversion systems.

In some embodiments, the method (500) further comprises a step of contacting the heating element of the power conversion system to the one or more cooling components (110) through at least one of said one or more openings (114) provided in the enclosure (100).

Advantageously, the proposed method (500) for assembling heat sinks is not relying on isolators. The proposed method (500) for assembling heat sinks discloses an easy way to assemble the one or more cooling components (110) and thus reduce assembling time.

The foregoing description of the specific embodiments will so fully reveal the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the phraseology or terminology employed herein is for the purpose of description and not of limitation. Therefore, while the embodiments herein have been described in terms of preferred embodiments, those skilled in the art will recognize that the embodiments herein can be practiced with modification within the scope of the disclosure.

## Claims

1. An enclosure (100) for power conversion systems, comprising:
a first block (102) having first alignment means (104);
a second block (106) having second alignment means (108) adapted to align with the first alignment means (104) to interlock the first block (102) with the second block (106), wherein the interlocked first block (102) and the second block (106) creates an internal compartment arranged to enclose one or more cooling components (110) of the power conversion systems; and
at least one rib structure (112) is arranged on internal wall of each of the first block (102) and the second block (106) to position and fixate the one or more cooling components (110) of the power conversion systems inside the enclosure,
wherein each of the first block (102) and second block (106) comprises one or more openings (114) to dissipate heat produced by one or more heating elements of the power conversion systems through heat exchange with one or more cooling components positioned inside the enclosure (100).

2. The enclosure (100) according to claim 1, wherein the first block (102) comprises a plurality of first sub-blocks (102a, 102b, ...,102n), wherein each first sub-block (102) comprises protruding means and slots (116), wherein slots are adapted to accommodate the one or more protruding means connecting the plurality of first sub-blocks (102a, 102b, ...1,02n) to each other.

3. The enclosure (100) according to claim 1, wherein the second block (106) comprises a plurality of second sub-blocks (106a, 106b, ...,106n), wherein each second sub-block (106) comprises protruding means and slots (116), wherein slots are adapted to accommodate the one or more protruding means connecting the plurality of second sub-blocks (106a, 106b, ...,106n) to each other.

4. The enclosure (100) according to any of the preceding claims, wherein first alignment means (104) and the second alignment means (108) comprises protruding means and slots, wherein the slots are adapted to accommodate the one or more protruding means to attach the first block (102) and the second block (106) to each other to form a sealed enclosure for housing the one or more cooling components (110) of the power conversion systems.

5. The enclosure (100) according to any of the preceding claims, wherein the interlocked first block (102) and the second block (106) creates an internal compartment arranged to enclose at least two cooling components (110) of the power conversion systems and wherein the at least one rib structure (112) is of variable dimensions and are arranged on the internal wall of each of the first block (102) and the second block (106) to maintain a predefined distance (112a, 112b), allowing the at least two cooling components (110) of the power conversion system to be electrically isolated from each other.

6. The enclosure (100) according to any of the preceding claims, wherein the one or more cooling components (110) of the power conversion systems comprises heat sinks.

7. The enclosure (100) according to any of the preceding claims, comprising each of the first block (102) and the second block (106) comprises one or more mounting surfaces (118) to assemble fans and/or one or more electronic components of the power conversion systems.

8. The enclosure (100) according to any of the preceding claims, wherein the first block (102) and/or the second block (106) is constructed from electrically isolating materials.

9. A power conversion system (400), comprising:
a power conversion circuit (402) and an enclosure (100) according to any one of claims 1-8; and
an arrangement integrated into the enclosure (100) to dissipate heat generated by the power conversion circuit (402), wherein the arrangement comprises:
one or more cooling components (110) of the power conversion system (400) disposed within the enclosure (100).

10. The power conversion system (400) according to claim 9, comprising at least one of a power board (404) and a control board (406), and wherein the one or more cooling components (110) disposed within the enclosure (100) comprises at least one heat sink, and wherein said power board (404) or the control board (406) thermally connected to said at least one heat sink through at least one of said one or more openings (114) provided in the enclosure (100).

11. A method (500) for arranging one or more cooling components (110) of a power conversion system (400) according to claims 9, comprising:
providing (502), an enclosure (100) according to any of claims 1-8, wherein the enclosure comprising a first block (102) and a second block (106);
arranging (504), the one or more cooling components (110) within the first block (102) of the enclosure (100); and
interlocking (506), the second block (106) with the first block (102), wherein the interlocked first block (102) and the second block (106) creates an internal compartment to enclose the one or more cooling components (110) of the power conversion systems.

12. The method according to claim 11, comprising the further step of contacting a heating element of the power conversion system (400) to the one or more cooling components through at least one of said one or more openings provided in the enclosure (100).
